(19) Europäisches Patentamt

European Patent Office

Office européen des brevets

(11) **EP 1 006 388 A2**

(12) **EUROPÄISCHE PATENTANMELDUNG**

(43) Veröffentlichungstag:
**07.06.2000 Patentblatt 2000/23**

(51) Int. Cl.⁷: **G02B 13/14**, G03F 7/20, G02B 17/08

(21) Anmeldenummer: **99121617.7**

(22) Anmeldetag: **30.10.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **09.02.1999 DE 19905203**
**30.11.1998 DE 19855158**
**27.02.1999 DE 19908544**

(71) Anmelder:
• **Carl Zeiss**
**89518 Heidenheim (Brenz) (DE)**
Benannte Vertragsstaaten:
**DE FR NL**
• **CARL-ZEISS-STIFTUNG, trading as CARL ZEISS**
**89518 Heidenheim (DE)**
Benannte Vertragsstaaten:
**GB**

(72) Erfinder: **Schuster, Karl-Heinz**
**89551 Königsbronn (DE)**

(54) **Reduktions-Projektionsobjektiv der Mikrolithographie**

(57)     Objektiv mit mehr als 10, insbesondere mehr als 17 Linsen (1-35), korrigiert bei einer Wellenlänge unter 200 nm, enthaltend Linsen (18, 23, 26) aus Quarzglas, dadurch gekennzeichnet, daß die Summe der Brechkräfte der Linsen (18, 23, 26) aus Quarzglas negativ ist. Quarzglas wird also als Flint verwendet. Als Kron dient Fluorid, besonders CaF$_2$, LiF, BaF oder SrF. Refraktive und katadioptrische Reduktions-Projektionsobjektive für 193 nm und 157 nm werden vorgestellt.

FIG.1

Printed by Xerox (UK) Business Services
2.16.7 (HRS)/3.6

EP 1 006 388 A2

**Beschreibung**

Die Erfindung betrifft ein Reduktions-Projektionsobjektiv der Mikrolithographie mit Linsen aus Quarzglas und Linsen aus Fluorid.

Ein derartiges refraktives Objektiv Cerco 823 aus Quarzglas und $CaF_2$ für 248 nm ist bereits in Babolat, C., Proc. Microcircuit Engineering Grenoble, France (1982), page 65-68 beschrieben.

Seitdem ist die Entwicklung so verlaufen, daß gattungsgemäße Objektive für den 193 nm-Exeimer-Laser entwickelt und gebaut werden, wie z.B. aus der nicht vorveröffentlichten Anmeldung DE 198 55 158.4 vom 30.11.1998 des gleichen Erfinders und Anmelders und aus dem dort genannten Stand der Technik bekannt ist. Jene Anmeldung und ihre Zitate sollen ausdrücklich Teil der Offenbarung dieser Anmeldung sein.

Bei den 248 nm und 193 nm Systemen ist dabei stets Quarzglas das Material der meisten Linsen, gemäß langer Tradition des UV-Linsenbaus, und es wird - aus Gründen der Verfügbarkeit, der Bearbeitbarkeit und der Kosten - möglichst wenig $CaF_2$ oder anderes Fluorid zur Achromatisierung eingesetzt.

Für 157 nm ($F_2$-Excimer-Laser) ist in der nicht vorveröffentlichten DE 198 44 158.4 des selben Erfinders und Anmelders erstmals ein rein refraktives Objektiv beschrieben, bei dem nun $CaF_2$ Basismaterial ist, ergänzt um einzelne Linsen aus anderen Fluoriden, insbesondere Bariumfluorid. Auch diese Anmeldung soll voll hier inkorporiert sein.

Aus EP 0 691 312 B1 ist ein Quarzglas bekannt, das als Besonderheit mit Fluor dotiert ist, dazu auch mit Wasserstoff, und das bei 157 nm brauchbare Transmission und Laserfestigkeit aufweist.

Die mögliche Anwendung von Elementen aus diesem Quarzglas im Objektiv einer Projektionsbelichtungsanlage der Mikrolithographie ist beschrieben, wobei lediglich wiederholt angegeben ist, daß es ein katadioptrisches Objektiv sein soll.

Aus EP 0 284 414 B1 ist ein refraktives Reduktions-Projektionsobjektiv der Mikrolithographie bekannt, das mit Linsen aus zwei verschiedenen Quarzglassorten aufgebaut ist. Mindestens eine Quarzglassorte ist mit Fremdstoffen dotiert, und zwar vorzugsweise mit Fluor. Die Eignung für 193 nm und größere Wellenlängen wird beschrieben.

Aus US 5,031,977 ist ein Projektionsobjektiv der Mikrolithographie bekannt, das Menisken aus Quarzglas und eine plankonvexe Linse aus LiF sowie Prismen aus $CaF_2$ aufweist. Als katadioptrisches 1:1 Objektiv mit zusätzlichem Spiegel, ausgelegt für 248 nm, ist es jedoch von einem erfindungsgemäßen Objektiv sehr verschieden.

Auch aus EP 0 835 848 A2 ist Fluor-dotiertes Quarzglas und seine Anwendung in Projektionsbelichtungsanlagen der Mikrolithographie, speziell bei 193 nm, bekannt.

Es ist auch bekannt, daß die Absorption von Quarzglas bei Herstellung nach dem Trockenabscheideverfahren zu niedrigeren Wellenlängen hin verschoben werden kann.

Aufgabe der Erfindung ist es, ein gattungsgemäßes Objektiv anzugeben, bei dem der Materialeinsatz hinsichtlich der Achromatisierung optimiert ist. Zugleich soll ein für Wellenlängen unter 200nm, und da besonders für 193 nm und für den $F_2$-Excimer-Laser bei 157 nm, geeignetes Objektiv angegeben werden, das eine erhöhte spektrale Bandbreite gegenüber $CaF_2$/$BaF_2$-Systemen und reinen Kalziumfluorid-Systemen ermöglicht.

Gelöst wird diese Aufgabe durch ein Reduktions-Projektionsobjektiv nach Anspruch 1, bei dem also die Summe der Brechkräfte der Linsen aus Quarzglas negativ ist, insbesondere ausschließlich Linsen negativer Brechkraft aus Quarzglas bestehen. Damit wird konsequent ausgenutzt, daß von den optischen Eigenschaften her für die Achromatisierung eines Objektivs aus Quarzglas und Fluorid, insbesondere $CaF_2$, möglichst das Quarzglas als Flint in Negativlinsen, das Fluorid als Kron in Positivlinsen einzusetzen ist. Die Angabe der Summe der Brechkräfte trägt der Tatsache Rechnung, daß diese Idee natürlich nicht schon durch den Einsatz einzelner Positivlinsen aus Quarzglas umgangen wird.

In bisheriger Übung wurde aus kommerziellen Gründen der Verfügbarkeit und des Preises und wegen der vorteilhafteren Bearbeitungsmöglichkeiten von Quarzglas bei vorbekannten Reduktions-Projektionsobjektiven für DUV einschließlich 193 nm stets der Fluorideinsatz minimiert und eine Beschränkung der Achromatisierung in Kauf genommen.

In Anspruch 2 ist der gleiche Erfindungsgedanke alternativ ausgefüllt: Ein Reduktions-Projektionsobjektiv der Mikrolithographie - das auch katadioptrisch sein kann - kombiniert Linsen aus $CaF_2$, einem anderen Fluorid-Kristall und Quarzglas und ist für Betriebswellenlängen unter 200 nm, vorzugsweise für die Excimer-Laser bei 193 nm oder 157 nm, ausgelegt. Damit eröffnen sich hervorragende Möglichkeiten der Achromatisierung auch in diesem VUV-Wellenlängenbereich.

Vorteilhafte Ausführungsformen sind Gegenstand der Unteransprüche 3 bis 14.

Gemäß Anspruch 3 sind ein bis zwei Negativlinsen in der Nähe der Systemblende aus Quarzglas gefertigt. Damit ergibt sich ein für die Achromatisierung optimaler Einsatz des Quarzglases als Flint.

Gemäß Anspruch 4 wird neben $CaF_2$ noch $BaF_2$ und/oder LiF als weiteres Linsenmaterial eingesetzt. Damit kann z.B. unter Nutzung der Erkenntnisse aus der o.g. DE 198 55 158.4 der Quarzglaseinsatz minimiert werden, und es bestehen beste Voraussetzungen für ein Objektiv bei 157 nm, wo die Absorption des Quarzglases einen sparsamen Einsatz erfordert.

Natürlich können auch andere Fluoride, zum Beispiel Strontiumfluorid, kombiniert werden.

Aus dem gleichen Grund der möglichst geringen Absorption ist es gemäß Anspruch 5 vorgesehen, das Quarzglas zu dotieren, vorzugsweise mit Fluor. Dies ist an sich aus den obengenannten EP 0 284 414 B1 und EP 0 691 312 B1 bekannt und hilft, die Transmission bei niedriger Wellenlänge zu verbessern.

Weitere optimale Einsatzorte für die verschiedenen Linsenmaterialien ergeben sich gemäß Anspruch 6 für Quarzglas oder $BaF_2$ in einer Strahltaille, also in einer Linsengruppe negativer Brechkraft, sowie gemäß Anspruch 7 mit LiF-Positivlinsen gepaart mit Quarzglas-Linsen in Blendennähe.

Die Systemblende liegt nach Anspruch 8 vorzugsweise zwischen zwei Linsen aus Quarzglas, gerade auch mit zwischengeschalteten Linsen aus anderem Material, z.B. nach Anspruch 7.

Nach Anspruch 9 ist vorgesehen, daß das erfindungsgemäße Objektiv drei Strahltaillen aufweist. Dies ist eine Taille mehr als z.B. in DE 198 55 158.4 und in den enthaltenen Zitaten angegeben ist. Zur Korrektur der Petzvalsumme ist die Ausbildung solcher Taillen und Bäuche erforderlich. Die Verteilung auf mehr Taille/Bauch-Gruppen ermöglicht dies bei Verringerung anderer Fehler und bei sehr kompakter Bauform. Materialeinsatz und Transmission werden also optimiert.

Eine Besonderheit ist auch, daß gemäß Anspruch 10 sowohl der Durchmesser der Strahltaillen wie auch der Strahlbäuche vom Objekt zum Bild zunimmt. Dies ermöglicht die für große Apertur nötige Ausbildung der langbrennweitigen Linsen großen Durchmessers nahe dem Bild bei kompakter Bauweise.

Die Eignung für anspruchsvolle Mikrolithographie zeigt sich in den Merkmalen der Ansprüche 11 und 12, wonach das Objektiv als Scanner-Objektiv, insbesondere mit ca. 26mm Schlitzhöhe (Vollfeld-Scanner), ausgebildet ist und die numerische Apertur (bildseitig) größer als 0,7, vorzugsweise größer als 0,75 ist. Im Beispiel wird sogar NA = 0,8 gezeigt.

Die erfindungsgemäßen Objektive erlauben bzw. bieten also einen großen Lichtleitwert von NA x Y' von 18 bis 20 mm.

Die Ausführung der ersten Taille erfolgt üblicherweise mit zwei negativen Menisken, die zur Taille hin konkav sind und sieht keine oder höchstens eine Positivlinse vor. Gemäß den Ansprüchen 13 und 14 wird eine neue Konstruktion für diesen Bereich aufgezeigt, die nur objektseitig einen negativen Meniskus vorsieht und/oder zwei Positivlinsen umfaßt.

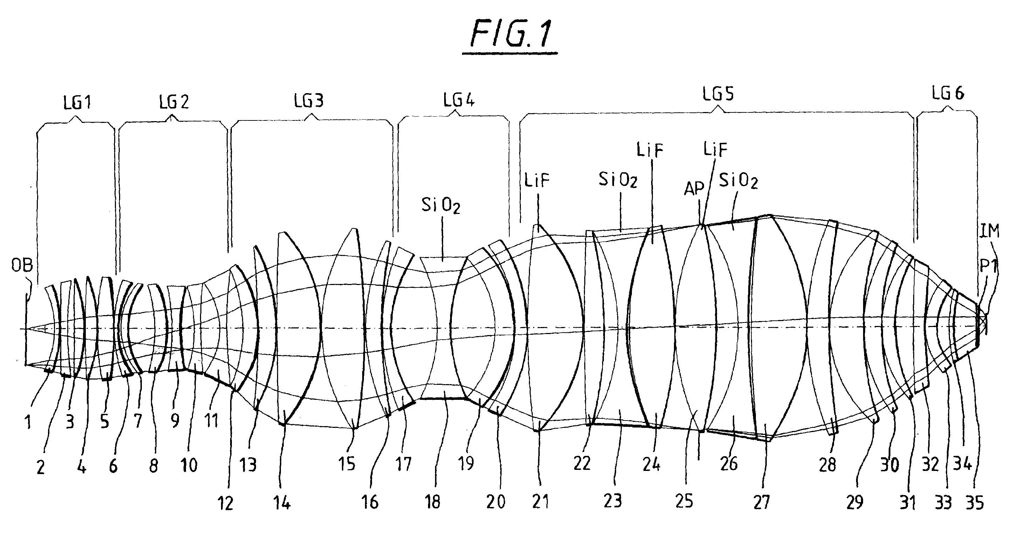

Anspruch 15 gibt die in den Ausführungsbeispielen nach den Fig. 1 bis 3 angegebene bevorzugte Ausführungsform als rein refraktives Reduktions-Projektionsobjektiv an. Hiermit werden Anwendungsbereiche für refraktive Objektive erschlossen, die bisher katadioptrischen oder katoptrischen Systemen vorbehalten schienen.

In einer Variante der Erfindung nach Anspruch 16 wird diese in einem Teilobjektiv angewandt, das zusammen mit einem katadioptrischen Teilobjektiv ein katadioptrisches Reduktionsobjektiv mit Zwischenbild ergibt.

Solche Objektive sind an sich z.B. als abgewandelte Schupmann-Achromate nach US 5,052,763, US 5,691,802 oder US Ser. No. 60/094579 vom 29.07.1998 bekannt.

Eine andere Variante sind koaxiale Objektive nach Art der DE 196 39 586 A1.

Durch erfindungsgemäße Ausführung des refraktiven Teilobjektivs werden Bandbreite, Korrektion und Bauaufwand verbessert.

Anspruch 17 erfüllt die Forderung nach optimalem Einsatz von Quarzglas zur Achromatisierung, mit der Eignung für niedrigste Wellenlängen bis zu ca 157 nm, durch die Beschränkung des Einsatzes von Quarzglas vorwiegend auf Negativlinsen auch für katadioptrische Reduktionsobjektive. Dies gilt insbesondere auch für solche mit Polarisationsstrahlteiler, wie sie an sich z.B. aus DE 196 16 922 A1 bekannt sind. Auch der katadioptrische Teil der zu Anspruch 16 erwähnten Objektive kann natürlich mit Vorteil so ausgebildet werden.

Anspruch 18 gibt für die Variante der Erfindung mit $CaF_2$, Quarzglas und mindestens einem weiteren Fluorid-Kristall ebenfalls die Ausführung als katadioptrisches Reduktionsobjektiv an.

Der oder die Spiegel der katadiopirischen Systeme werden also nicht mehr ausschließlich für die Achromatisierung benötigt, so daß der Konstruktionsspielraum erweitert wird und das Design breitbandiger, gut korrigierter kompakter Objektive hoher Apertur mit großem Bildfeld - also mit hohem Lichtleitwert - erleichtert wird.

Unteranspruch 19 gibt wie schon Anspruch 5 die Dotierung des Quarzglases vorzugsweise mit Fluor an, mit der insbesondere die Transmission bei 157 nm entscheidend verbessert werden kann.

Anspruch 20 gibt die Grundidee der Verwendung des Quarzglases als Negativlinsen in ganz reiner und allgemeiner Form wieder, während Anspruch 21 der Tatsache Rechnung trägt, daß natürlich auch beim zusätzlichen Einsatz nur einzelner Positivlinsen aus Quarzglas die Erfindung gewahrt bleibt. Die angegebene Linsenzahl von 10 oder mehr Linsen hebt die Erfindung dabei von relativ einfachen katadioptrischen Projektionsobjektiven oder Mikroskopobjektiven ab. Ab ca. 17 Linsen werden schon hochwertige Projektionsobjektive, mit Asphären oder als Stitching-Objektive, auch rein refraktiv möglich.

Anspruch 22 umfaßt eine Projektionsbelichtungsanlage der Mikrolithographie mit erfindungsgemäßem Reduktions-Projektionsobjektiv, die insbesondere für die Verwendung von 193 nm oder 157 nm Exeimer-Laser-Licht hervorragend geeignet ist und die Mikrolithographie mit Strukturbreiten im Bereich 0,15 bis 0,10 µm zugänglich macht.

Gemäß Anspruch 23 ist ein Herstellverfahren für mikrolithographisch strukturierte Objekte - also z.B. von integrierten elektrischen, optoelektronischen oder anderen Schaltkreisen - dadurch gekennzeichnet, daß eine Projektionsbelichtungsanlage nach dem vorgenannten Anspruch 21 verwendet wird. Demnach wird also die Projektion mit Verkleinerung eingesetzt, bei der vorzugsweise Licht sehr niedriger Wellenlängen mit üblicher Bandbreite bei guter Achromatisierung durch den besonderen Einsatz von Quarzglas, speziell auch in Verbindung mit verschiedenen Fluorid-Kristallen, die Bildgebung bewirkt.

Näher erläutert wird die Erfindung anhand der Zeichnungen.

Es zeigen:

Figur 1      den Linsenschnitt eines ersten Ausführungsbeispiels;

Figur 2      den Linsenschnitt eines zweiten Ausführungsbeispiels;

Figur 3      den Linsenschnitt eines dritten Ausführungsbeispiels;

Figur 4      schematisch ein katadioptrisches Reduktionsobjektiv gemäß der Erfindung;

Figur 5      schematisch eine Projektionsbelichtungsanlage gemäß der Erfindung.

Figur 6      typische Bildfehlerverläufe zum Beispiel der Fig. 1

Das in Fig. 1 dargestellte Projektionsobjektiv hat die in Tab. 1 angegebenen Konstruktionsmaße. Bei einer Länge Objekt-Bild Ob-IM von 1540,1 mm weist es eine bildseitige numerische Apertur von NA = 0,8 auf Der Abbildungsmaßstab ist 1:4, es ist beidseitig telezentrisch. Die Betriebswellenlänge ist 157,630 nm $\pm$ 5 pm bis $\pm$ 8 pm.

Die für das Design verwendeten Brechzahlen sind in Tabelle 2 angegeben. Für diese extreme Wellenlänge sind die optischen Daten noch nicht voll etabliert.. Insbesondere für Quarzglas hängen die exakten Werte auch von der Dotierung ab. Einfache Anpassungen des Designs an abweichende Brechzahlen von Material-Chargen sind aber möglich.

Das Bildfeld von 8 x 26 mm$^2$ Rechteck ist für einen Vollfeld-Scanner ausgelegt.

Bei dem von numerischer Apertur und Bildfeld festgelegten großen Lichtleitwert dieses Objektivs ist der Linsendurehmesser wie die Baulänge beträchtlich. Bei Reduktion von Bildfeld (z. B. bei einem Stitching-Objektiv) oder Apertur schrumpft dieser Durchmesser wie die Baulänge und die Linsenzahl sofort. Ähnliches kann auch bei Einführung von Asphären erreicht werden.

Der RMS-Fehler liegt für alle Bildhöhen unter 15 Millilambda (2,3 nm).

Die Grundlage dieses Objektivdesigns ist die konsequente Verwendung von Quarzglas als Flintglas zur Achromatisierung. Gepaart wird es mit Lithiumfluorid und Kalziumfluorid als Kronglas. Kalziumfluorid wird als Basismaterial für die Mehrzahl der Linsen 1-17, 19, 20, 22, 27-35 vorgesehen, da es von seinen Werkstoffeigenschaften und der Verfügbarkeit her bei dieser Wellenlänge vorzuziehen ist

Demgemäß sind an der Systemblende AP zwei Negativlinsen 23, 26 aus Quarzglas mit zwei Positivlinsen 24, 25 aus Lithiumfluorid gepaart, in klassischer Achromatanordnung. Durch die Verwendung von Lithiumfluorid ist gegenüber Kalziumfluorid der Dispersionsabstand gesteigert, was eine stärkere achromatisierende Wirkung bedeutet. Nur eine weitere Negativlinse 18 aus Quarzglas, angeordnet in der Strahltaille der Linsengruppe LG4, und eine Lithiumfluorid-Linse 21 darauffolgend in der fünften Linsengruppe LG5 werden daher zusätzlich benötigt, um die Farbkorrektur für die Bandbreite von $\pm$ 5 bis 15 pm zu erreichen. Dies ist wichtig, da das Quarzglas bei 157 nm relativ hohe Absorption aufweist, so daß möglichst wenig davon in den Lichtweg gebracht werden soll.

Quarzglas unterliegt auch den Störungen durch Lens Heating - Veränderung von Volumen und Brechungsindex durch Erwärmung aufgrund der Absorption - und Compaction - Veränderung durch Langzeitwirkung der UV-Bestrahlung. Beides wird dadurch gemildert, daß Quarzglas in Negativlinsen eingesetzt wird, die besser über ihren Rand gekühlt werden können, und daß in Blendennähe auch bei einem Scanner mit schlitzförmigem Bildfeld eine weitgehend rotationssymmetrische Verteilung der Strahlungsbelastung über den ganzen Linsenquerschnitt erfolgt. Letzteres entspannt auch die Anforderungen an die Lithiumfluorid-Linsen 24, 25, deren Material gegenüber Kalziumfluorid weniger strahlungsresistent ist. Zur besseren Kühlung der Quarzglaslinsen kann auch ihre Aufteilung in mehrere dünne Linsen vorgesehen werden.

Der konstruktive Aufbau mit 35 Linsen 1 bis 35 zeigt Ähnlichkeiten mit jüngeren DUV-Objektiven mit 6 Linsengruppen: Die positive LG1, negative LG2, positive LG3, negative LG4, aufwendige positive LG5, enthaltend die Systembiende AP und die wesentlichen Teile der Achromatisierung, und die abschließende LG6. Eine Planplatte P1 schließt das Objektiv zur Bildebene IM hin ab.

Die negativen Linsengruppen LG2 und LG4 werden gewöhnlich von negativen, nach außen konvexen Menisken abgeschlossen. Hier ist das nur bei der LG4 mit den Linsen 17 und 20 der Fall. Bei der LG2 ist nur noch objektseitig ein solcher Meniskus 6 vorhanden, gefolgt von zwei positiven Menisken 7, 8 und drei bikonkaven Linsen 10, 11, 12. Hier ist also ein vielgliedriger Aufbau vorgesehen, der gute Korrekturmöglichkeiten schafft, welche bei den hier kleinen Linsen mit wenig Platz- und Materialaufwand ermöglicht werden.

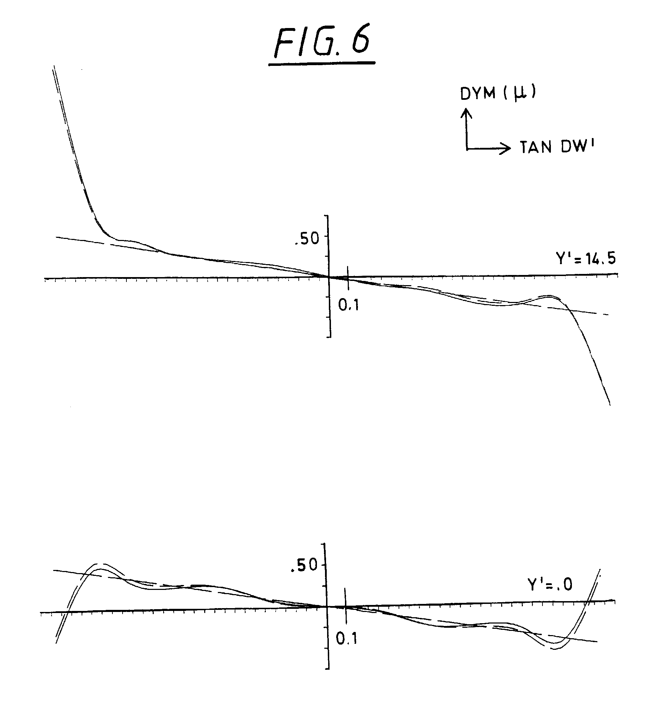

Fig. 6 zeigt für dieses Objektiv die Queraberration DYM im meridionalen Hauptschnitt als Funktion des Tangens des Aperturwinkels TAN DW' für die maximale Bildhöhe Y' = 14,5 mm und auf der Achse Y' = 0 mit sehr guter Qualität.

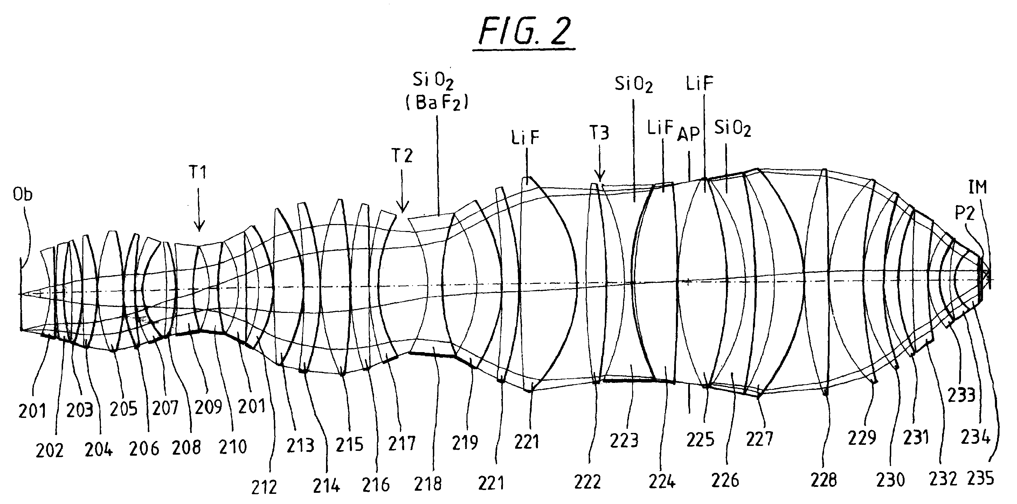

Ein zweites Ausführungsbeispiel eines refraktiven Scanner-Objektivs für die 157 nm Mikrolithographie zeigt Fig. 2. Es besteht ebenfalls aus 35 Linsen 201 bis 235 und einer Abschlußplatte P2, hat das gleiche Bildfeld und den Maßstab 1:4. Der Abstand Ob-Im beträgt 1455,6 mm, das Objektiv ist also etwas kompakter als das erste Beispiel. Auch hier liegt der RMS-Fehler für alle Bildhöhen unter 15 Millilambda (2,3 nm).

Linsenmaterial ist wiederum Kalziumfluorid für alle Linsen mit Ausnahme der Negativlinsen 218, 223 und 226 aus Quarzglas und der Positivlinsen 221, 224 und 225 aus Lithiumfluorid.

Alternativ ist vorgesehen, die Linse 218 aus Bariumfluorid zu machen. Hier ist die Strahlungsbelastung ungünstiger als bei den blendennahen Linsen 223 und 226, so daß hier eventuell eine geringere achromatisierende Wirkung zugunsten einer höheren Belastbarkeit des Bariumfluorid-Kristalls akzeptiert werden kann. Als Fluorid-Kristalle kommen neben Kalziumfluorid, Lithiumfluorid und Bariumfluorid, welche oben explizit beschrieben sind, auch die anderen Fluoride wegen ihrer besonderen Transmission im tiefen Ultraviolett in Frage. Besonders ist auch an Strontiumfluorid zu denken.

Abweichend von Fig. 1 zeigt der Objektivautbau hier die deutliche Ausbildung von drei Strahltaillen T1, T2, T3. Die dritte Taille T3 ist nahe der Systemblende AP an der Quarzglaslinse 223 ausgebildet. Entsprechend weist die Konstruktion vier Bäuche B1 bis B4 auf.

Die negative Linsengruppe an der ersten Strahltaille T1 weist hier nur eine positive Linse 208 auf

Bei diesem Beispiel ist auch die oben beschriebene Ausbildung mit von der Objektebene Ob zur Bildebene IM hin anwachsendem Durchmesser sowohl der Taillen T1 bis T3 als auch der Bäuche B1 bis B4 verwirklicht, mit den beschriebenen Vorteilen.

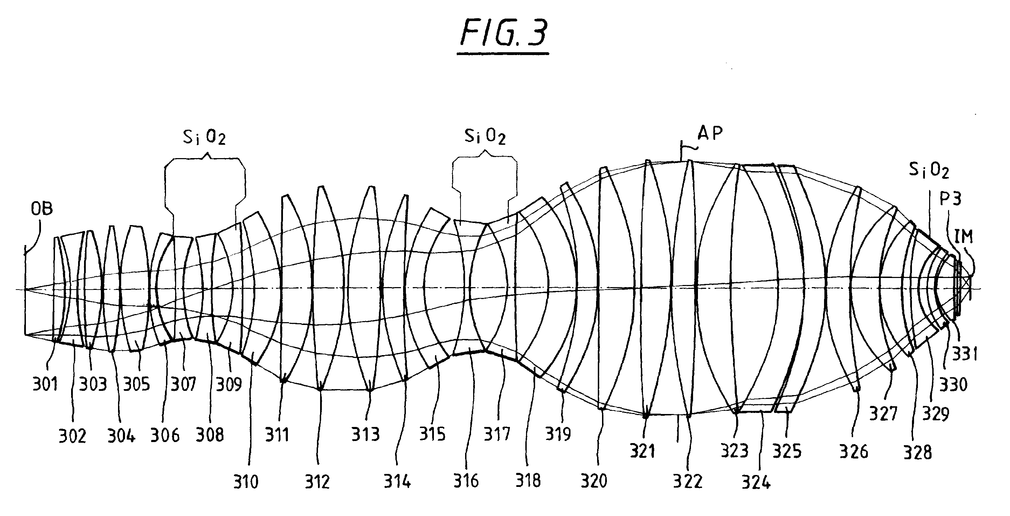

Das Ausführungsbeispiel nach Fig. 3 und Tab. 3 ist hingegen ein refraktives Objektiv mit der Betriebswellenlänge 193 nm. Herkömmliche Konstruktionen für dieses Anwendungsgebiet benutzen die Materialpaarung Kalziumfluorid und Quarzglas dergestalt, daß nur wenige Kalziumfluorid-Linsen zur Achromatisierung des auf Quarzglas basierenden Objektivs herangezogen werden. Dies ist begründet durch die bisher schlechte Verfügbarkeit großer Kalziumfluorid-Linsenrohlinge und durch die vergleichsweise gegenüber Quarzglas schlechte Polierbarkeit der Einkristalle. Hier wird aber nun die beste Nutzung der optischen Eigenschaften in den Vordergrund gestellt. Demnach ist Quarzglas als Kronglas und Kalziumfluorid als Flintglas in der Weise einzusetzen, daß das Quarzglas als Negativlinsen mit Positivlinsen aus Kalziumfluorid zur Achromatisierung kombiniert wird. Durch den jetzt verringerten Einsatz von Quarzglas werden auch die Probleme des Lens Heating und der Compaction verringert.

Im Beispiel sind demgemäß nur die sechs Negativlinsen 307, 308, 309 an der ersten Strahltaille, 316, 317 an der zweiten Strahltaille und 328 nahe der Bildebene IM aus Quarzglas ausgebildet. Im Bereich der Systemblende AP sind in diesem Beispiel keine Achromat-Gruppen vorgesehen.

Bei einer Bandbreite von 0,5 pm weist das Beispiel eine chromatische Längsaberration von 0,15 μm auf Der RMS-Fehler liegt für alle Bildhöhen unter 16,3 Millilambda (2,56 nm). Mit der großen bildseitigen Apertur NA = 0,8 , dem Maßstab 1:4, beidseitiger Telezentrie und dem Bildfeld 26 x 8 mm$^2$ hat das Objektiv den sehr kompakten Abstand Ob-IM von 1150 mm und kommt mit 31 Linsen 301 bis 331 aus. P3 ist wiederum eine plane Abschlußplatte.

Beachtlich ist, daß alle gezeigten refraktiven Projektionsobjektive der Fig. 1 bis Fig. 3 rein sphärische Linsen aufweisen. Klar ist, daß mit asphärischen Linsen der Kompromiß von Linsenzahl und Objektivgröße zur Abbildungsleistung noch weiter verbessert werden kann.

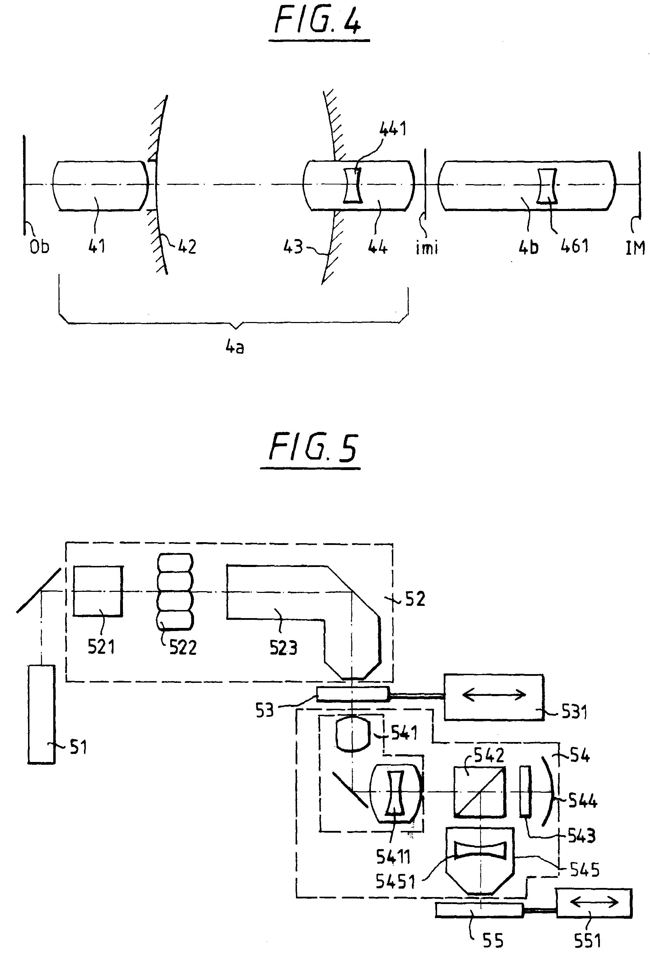

Die Fig. 4 zeigt schematisch ein weiteres Ausführungsbeispiel der Erfindung, es ist ein Objektiv mit Zwischenbild (imi) und einem refraktiven Teilobjektiv 4b und einem katadioptrischen Teilobjektiv 4a. In beiden können erfindungsgemäß Quarzglaslinsen ausschließlich als Negativlinsen 441 oder 461 vorgesehen werden. Die weiteren Linsen der Linsengruppen 41, 44 und des Teilobjektivs 4b bestehen dann aus Kalziumfluorid und/oder einem anderen Fluorid. Natürlich können auch konventionelle Linsengrupppen kombiniert werden. Der gezeigte koaxiale Aufbau mit den zwei Spiegeln 42, 43 ist an sich z. B. aus der DE 196 39 586 A1 bekannt.

Fig. 5 zeigt schematisch ein Ausführungsbeispiel einer kompletten Projektionsbelichtungsanlage der Mikrolithographie. Als Lichtquelle 51 dient ein Excimer-Laser mit vorzugsweise 248, 193 oder 157 nm Wellenlänge. Eine Beleuchtungseinrichtung 52 umfaßt Linsen/Spiegel-Gruppen 521, 523 und einen Homogenisator, insbesondere einen Wabenkondensor. Auch ein Glasstab ist hier denkbar. Ein Beispiel für eine solche auch für 157 nm taugliche Beleuchtungseinrichtung findet sich in der deutschen Patentanmeldung DE 198 55 106. Die Maske 53 wird von einem System 531 gehalten, justiert, gescant und gewechselt. Das Projektionsobjektiv 54 ist als katadioptrisches Reduktionsobjektiv mit Polarisations-Strahlteiler 542 und einem Konkavspiegel 544 sowie Linsengruppen 541, 543, 545 ausgeführt, wie es beispielsweise aus DE 196 16 922 A1 bekannt ist. Das zu belichtende Objekt 55, gewöhnlich ein Wafer zur Mikrochipherstellung, wird von einem System 551 gehalten, justiert, gescant und gewechselt. Weitere Einrichtungen wie Autofokussystem, Linsenmanipulatoren, Regelsysteme usw. sind bei Projektionsbelichtungsanlagen der Mikrolithographie bekannt notwendig und hier nicht dargestellt.

Erfindungsgemäß sind in dem Objektiv 54 nur die Negativlinsen 5411, 5451 aus Quarzglas gefertigt. Basismaterial der Linsen ist Kalziumfluorid. Beispielswiese in der Linsengruppe 543 kann aber auch ein anderes Fluorid mit verwendet werden.

Klar ist, daß auch andere Elemente zu einer erfindungsgemäßen Projektionsbelichtungsanlage mit erfindungsgemäßem Objektiv zusammengestellt werden können.

Die beschriebenen Ausführungsformen sind nur Beispiele für die in den Ansprüchen festgelegte Erfindung. Insbesondere sind auch Kombinationen der Beispiele und Varianten vorteilhaft möglich.

## T A B E L L E  1

| Element | Radien | Dicken | Gläser |
|---|---|---|---|
| Ob | - | 45.640 | |
| 1 | -141.404 | 7.317 | CaF2 |
| | -221.495 | 1.988 | |
| 2 | 10014.863 | 11.476 | CaF2 |
| | 550.762 | 10.673 | |
| 3 | -15523.603 | 17.400 | CaF2 |
| | -221.961 | .144 | |
| 4 | 1300.540 | 18.500 | CaF2 |
| | -265.439 | .110 | |
| 5 | 418.505 | 27.260 | CaF2 |
| | -790.362 | .050 | |
| 6 | 238.689 | 6.197 | CaF2 |
| | 125.491 | 4.512 | |
| 7 | 111.036 | 11.213 | CaF2 |
| | 117.628 | 42.523 | |
| 8 | -236.214 | 18.628 | CaF2 |
| | -169.181 | 8.977 | |
| 9 | -332.441 | 12.241 | CaF2 |
| | 243.348 | 23.482 | |
| 10 | -202.521 | 10.000 | CaF2 |
| | 815.972 | 30.627 | |
| 11 | -116.923 | 11.487 | CaF2 |
| | 823.017 | 25.597 | |
| 12 | -228.669 | 23.146 | CaF2 |
| | -168.873 | .751 | |

| | | | |
|---|---|---|---|
| 13 | -1325.421 | 30.200 | CaF2 |
| | -274.449 | .771 | |
| 14 | 5034.234 | 69.297 | CaF2 |
| | -237.888 | .806 | |
| 15 | 293.933 | 68.217 | CaF2 |
| | -1091.384 | 2.061 | |
| 16 | 323.344 | 25.754 | CaF2 |
| | 674.492 | .907 | |
| 17 | 347.176 | 13.498 | CaF2 |
| | 202.739 | 75.252 | |
| 18 | -241.746 | 21.276 | Quarzglas |
| | 249.273 | 72.000 | |
| 19 | -160.892 | 32.500 | CaF2 |
| | -182.327 | .750 | |
| 20 | -219.478 | 19.298 | CaF2 |
| | -254.487 | .751 | |
| 21 | 1445.240 | 89.777 | LiF |
| | -228.368 | 1.970 | |
| 22 | 5171.138 | 31.833 | CaF2 |
| | -640.864 | 22.361 | |
| 23 | -314.265 | 15.102 | Quarzglas |
| | 373.112 | 2.855 | |
| 24 | 391.011 | 74.429 | LiF |
| | -590.194 | 40.000 | |
| AP | - | -40.000 | |
| 25 | 376.390 | 67.000 | LiF |
| | -682.308 | 34.467 | |
| 26 | -295.655 | 16.777 | Quarzglas |
| | 1269.117 | 4.300 | |
| 27 | 1610.404 | 89.605 | CaF2 |
| | -305.914 | .751 | |

| | | | |
|---|---|---|---|
| 28 | 443.806 | 35.289 | CaF2 |
| | 1067.480 | .750 | |
| 29 | 206.523 | 54.196 | CaF2 |
| | 481.871 | .750 | |
| 30 | 238.768 | 28.328 | CaF2 |
| | 357.025 | .750 | |
| 31 | 179.002 | 21.481 | CaF2 |
| | 239.040 | 28.958 | |
| 32 | 2574.744 | 19.041 | CaF2 |
| | 870.773 | .300 | |
| 33 | 115.013 | 18.212 | CaF2 |
| | 96.781 | 18.665 | |
| 34 | 239.152 | 6.467 | CaF2 |
| | 222.490 | 1.580 | |
| 35 | 208.024 | 34.625 | CaF2 |
| | 594.953 | 3.037 | |
| P1 | --- | 1.875 | CaF2 |
| | --- | 11.259 | |
| IM | --- | | |

TABELLE 2

| Material | Index | |
|---|---|---|
| | $\lambda = 157{,}625$ | $\lambda = 157{,}635$ |
| $CaF_2$ | 1,55 8423 | 1,55 8397 |
| LiF | 1,47 8109 | 1,47 8094 |
| Quarzglas | 1,65 8774 | 1,65 8725 |

9

## TABELLE 3

| FL | Radien | Dicken | Gläser |
|---|---|---|---|
| 0b | ∞ | 34.982 | |
| 301 | -4088.407 | 12.912 | CaF2 |
| | -251.776 | 7.160 | |
| 302 | -162.976 | 7.012 | CaF2 |
| | 332.656 | 8.317 | |
| 303 | 638.323 | 22.473 | CaF2 |
| | -201.060 | .750 | |
| 304 | 376.236 | 20.205 | CaF2 |
| | -396.540 | .750 | |
| 305 | 267.266 | 33.457 | CaF2 |
| | -392.008 | .750 | |
| 306 | 188.384 | 8.018 | CaF2 |
| | 107.326 | 24.194 | |
| 307 | -861.055 | 8.364 | Quarzglas |
| | 173.499 | 24.642 | |
| 308 | -200.368 | 8.851 | Quarzglas |
| | 402.418 | 26.633 | |
| 309 | -124.647 | 12.381 | Quarzglas |
| | -884.148 | 13.344 | |
| 310 | -232.499 | 31.578 | CaF2 |
| | -168.623 | .750 | |
| 311 | -7947.837 | 36.667 | CaF2 |
| | -226.212 | .750 | |
| 312 | 1155.936 | 37.063 | CaF2 |
| | -309.718 | 4.962 | |
| 313 | 312.669 | 39.669 | CaF2 |
| | -819.836 | 2.577 | |

| | | | |
|---|---|---|---|
| 314 | 268.974 | 25.816 | CaF2 |
| | 1540.243 | 1.206 | |
| 315 | 169.903 | 21.860 | CaF2 |
| | 127.436 | 50.392 | |
| 316 | -247.837 | 6.022 | Quarzglas |
| | 154.186 | 46.893 | |
| 317 | -128.207 | 10.035 | Quarzglas |
| | 3266.627 | 39.908 | |
| 318 | -128.717 | 33.440 | CaF2 |
| | -162.119 | .811 | |
| 319 | -346.157 | 25.400 | CaF2 |
| | -225.229 | .777 | |
| 320 | 4370.082 | 43.576 | CaF2 |
| | -313.397 | 7.351 | |
| 321 | 2290.147 | 36.497 | CaF2 |
| | -473.451 | 10.000 | |
| AP | ∞ | -10.000 | |
| | | | |
| 322 | 613.402 | 29.316 | CaF2 |
| | -2794.107 | .750 | |
| 323 | 263.709 | 41.995 | CaF2 |
| | 1088.392 | 56.916 | |
| 324 | -267.395 | 31.647 | CaF2 |
| | -308.065 | .966 | |
| 325 | -337.948 | 25.505 | CaF2 |
| | -294.154 | 1.084 | |
| 326 | 226.085 | 28.352 | CaF2 |
| | 549.259 | .966 | |
| 327 | 123.477 | 34.813 | CaF2 |
| | 225.081 | .759 | |
| 328 | 113.400 | 26.294 | CaF2 |

| | | | |
|---|---|---|---|
| | 181.384 | 10.360 | |
| 329 | 306.612 | 9.814 | Quarzglas |
| | 60.269 | 10.603 | |
| 330 | 72.285 | 8.840 | CaF2 |
| | 55.167 | .750 | |
| 331 | 49.774 | 24.086 | CaF2 |
| | 358.667 | 4.638 | |
| P3 | ∞ | 2.492 | CaF2 |
| | ∞ | 13.082 | |
| IM | ∞ | .000 | |

**Patentansprüche**

1.  Refraktives Reduktions-Projektionsobjektiv der Mikrolithographie mit Linsen aus Quarzglas und Linsen aus Fluorid, dadurch gekennzeichnet, daß die Summe der Brechkräfte der Linsen aus Quarzglas negativ ist, vorzugsweise daß ausschließlich Linsen (18, 23, 26) negativer Brechkraft aus Quarzglas bestehen.

2.  Reduktions-Projektionsobjektiv der Mikrolithographie mit einer Betriebswellenlänge unter 200 nm, vorzugsweise 193 nm oder 157 nm, mit Linsen aus $CaF_2$ (1-17, 19, 20, 22, 27-35) und einem anderen Fluorid-Kristall (21, 24, 25) und mit mindestens einer Linse (18, 23, 26) aus Quarzglas.

3.  Reduktions-Projektionsobjektiv nach Anspruch 1 oder 2, dadurch gekennzeichnet, daß mindestens eine, vorzugsweise ein bis zwei, Negativlinsen (23, 26) in Blendennähe aus Quarzglas sind.

4.  Reduktions-Projektionsobjektiv nach Anspruch 1, 2 oder 3, dadurch gekennzeichnet, daß neben $CaF_2$ noch Bariumfluorid und/oder LiF als weiteres Linsenmaterial eingesetzt ist.

5.  Reduktions-Projektionsobjektiv nach mindestens einem der Ansprüche 1 bis 4, dadurch gekennzeichnet, daß das Quarzglas dotiert ist, insbesondere mit Fluor.

6.  Reduktions-Projektionsobjektiv nach mindestens einem der Ansprüche 1 bis 5, dadurch gekennzeichnet, daß eine Negativlinse (18) im Bereich einer Strahltaille aus Quarzglas oder $BaF_2$ besteht.

7.  Reduktions-Projektionsobjektiv nach mindestens einem der Ansprüche 3 bis 6, dadurch gekennzeichnet, daß den Quarzglas-Linsen (23, 26) in Blendennähe Positivlinsen (24, 25) aus LiF benachbart sind.

8.  Reduktions-Projektionsobjektiv nach mindestens einem der Ansprüche 3 bis 7, dadurch gekennzeichnet, daß die Systemblende (AP) zwischen zwei Linsen aus Quarzglas (23, 26) angeordnet ist, fallweise mit zwischengeschalteten Linsen (24, 25) aus anderem Material.

9.  Reduktions-Projektionsobjektiv nach mindestens einem der Ansprüche 1 bis 8, dadurch gekennzeichnet, daß es drei Strahltaillen (T1, T2, T3) aufweist.

10. Reduktions-Projektionsobjektiv nach Anspruch 9, dadurch gekennzeichnet, daß der Durchmesser der Strahltaillen (T1, T2, T3) und Strahlbäuche (B1, B2, B3, B4) vom Objekt (Ob) zum Bild (IM) zunimmt.

**11.** Reduktions-Projektionsobjektiv nach mindestens einem der Ansprüche 1 bis 10, dadurch gekennzeichnet, daß das Objektiv mit einem Bildfeldradius von über 25 mm ausgebildet ist.

**12.** Reduktions-Projektionsobjektiv nach mindestens einem der Ansprüche 1 bis 11, dadurch gekennzeichnet, daß die bildseitige numerische Apertur größer als 0,7, vorzugsweise größer als 0,75 ist.

**13.** Reduktions-Projektionsobjektiv nach mindestens einem der Ansprüche 1 bis 12, dadurch gekennzeichnet, daß im Bereich der ersten Taille (T1) nur objektseitig ein negativer Meniskus (6, 207) angeordnet ist.

**14.** Reduktions-Projektionsobjektiv nach Anspruch 13, dadurch gekennzeichnet, daß im Bereich der ersten Taille (T1) zwei Positivlinsen (7, 8) angeordnet sind.

**15.** Reduktions-Projektionsobjektiv nach mindestens einem der Ansprüche 2 bis 14, dadurch gekennzeichnet, daß es rein refraktiv aufgebaut ist.

**16.** Katadioptrisches Reduktionsobjektiv der Mikrolithographie mit Zwischenbild (imi) und refraktivem Teilobjektiv (4b), dadurch gekennzeichnet, daß das refraktive Teilobjektiv (4b) nach mindestens einem der Ansprüche 1 bis 15 ausgeführt ist.

**17.** Katadioptrisches Reduktionsobjektiv der Mikrolithographie, insbesondere mit Linsengruppen (541, 543, 545) enthaltend mindestens eine Linse (5411, 5451) aus Quarzglas, einem Polarisations-Strahlteiler (542) und einem Konkavspiegel (544), dadurch gekennzeichnet, daß die Summe der Brechkräfte der Linsen (5411, 5451) aus Quarzglas negativ ist, vorzugsweise daß ausschließlich Linsen (5411, 5451) negativer Brechkraft aus Quarzglas bestehen.

**18.** Katadioptrisches Reduktionsobjektiv der Mikrolithographie, dadurch gekennzeichnet, daß Linsen aus $CaF_2$ (541), mindestens einem anderen Fluorid-Kristall (543) und aus Quarzglas (5411, 5451) enthalten sind.

**19.** Katadioptrisches Reduktionsobjektiv der Mikrolithographie nach Anspruch 17 oder 18, dadurch gekennzeichnet, daß mindestens eine Linse (5411, 5451) aus vorzugsweise mit Fluor dotiertem Quarzglas besteht.

**20.** Objektiv mit mehr als 10, vorzugsweise mehr als17 Linsen (1-35), enthaltend Linsen (18, 23, 26) aus Quarzglas, dadurch gekennzeichnet, daß alle Linsen (18, 23, 26) aus Quarzglas Negativlinsen sind.

**21.** Objektiv mit mehr als 10, vorzugsweise mehr als 17 Linsen (1-35), korrigiert bei einer Wellenlänge unter 200 nm, enthaltend Linsen (18, 23, 26) aus Quarzglas, dadurch gekennzeichnet, daß die Summe der Brechkräfte der Linsen (18, 23, 26) aus Quarzglas negativ ist.

**22.** Projektionsbelichtunganlage der Mikrolithographie umfassend eine Lichtquelle (51) mit einer Wellenlänge unter 200 nm, vorzugsweise mit 193 nm oder 157 nm,

ein Beleuchtungssystem (52)
ein Masken-Halte-Positionier-und-Bewegungs-System (531)
ein Reduktions-Projektionsobjektiv (54) nach mindestens einem der Ansprüche 1 bis 21, und
ein Objekt-Halte-Positionier-und-Bewegungs-System (551)

**23.** Mikrolithographische Bearbeitung eines Objekts unter Verwendung einer Projektionsbelichtungsanlage nach Anspruch 22.

# FIG.1

EP 1 006 388 A2

*FIG. 2*

SiO₂
(BaF₂)

SiO₂   LiF

LiF   SiO₂

LiF   T3   LiF AP   SiO₂

T2

T1

Ob

IM

P2

EP 1 006 388 A2

201  203  205  207  209  201         213  215  217  219  221  223  225  227  229  231  234  233

202  204  206  208  210         212  214  216  218  221  222  224  226  228  230  232 235

# FIG.3

# FIG.4

# FIG.5

## FIG. 6

DYM ( μ )

TAN DW'

.50

Y' = 14.5

0.1

.50

Y' = .0

0.1